# EUROPEAN PATENT SPECIFICATION

(11) **EP 1 521 166 B1**
(45) Date of publication and mention of the grant of the patent: **20.02.2013**
(21) Application number: 03022516.3
(22) Date of filing: 02.10.2003
(51) Int. Cl.: G06F 1/32, H03M 11/22, G06F 3/023

(54) **Keyboard**
Tastatur
Clavier

(43) Date of publication of application: 06.04.2005
(73) Proprietor: HTC Corporation, Taoyuan County 330 (TW)
(72) Inventor: Cheng, Yi-Tsung, Taipei Hsien (TW)
(74) Representative: Weber, Joachim

(56) References cited:
- EP-A- 0 478 141
- EP-A2- 1 189 025
- WO-A-99/62180
- WO-A2-03/030363
- US-A- 3 765 015
- US-A- 3 973 256
- US-A- 5 386 584
- US-A- 5 585 792
- US-A- 5 653 637
- US-A- 5 700 194
- US-A- 5 877 752
- US-A1- 2002 171 564
- US-B1- 6 169 261
- US-B1- 6 198 820

## Description

The present invention relates to a keyboard according to claim 1.

It the state-of-the-art keyboard, whenever any key cell within a matrix key module is pressed, a processor is required to continuously poll the input signals on the output ends of the key cells until every key cell within the matrix key module is released. This continuous polling lowers the efficiency of the processor.

European Patent No. EP-A-0478141 discloses a keyboard status reporting system that provides an indication over a serial bus as to which switch of a plurality of keypad switches is being selected by an operator. While this disclosure eliminates the need for continuous polling of the output ends of individual key cells, continuous polling of the serial bus is still employed, again lowering processor efficiency potentials.

US3765015 discloses a keyboard with a plurality of key cells, and a switch monitoring circuitry with a detect circuit for detecting switch closure without the need for polling. Only switch closure can be detected by this technology. WO 99/62180 discloses another passive keypad.

This in mind, the present invention aims at providing a keyboard having a processor that reads input signals at an output end of a key cell only when any of the key cells within the key module are pressed or released.

This is achieved by a keyboard according to claim 1. The dependent claims pertain to corresponding further developments and improvements.

As will be seen more clearly from the detailed description following below, the claimed keyboard includes a detect circuit, a parallel-to-serial register, and a processor. The detect circuit is electrically connected to an output end of a key cell for generating a control signal whenever the voltage on the output end changes. The processor is electrically connected to the parallel-to-serial register and the detect circuit for controlling the parallel-to-serial register according to the control signal. The processor controls the parallel-to-serial register to first do a parallel read of the input signals on the output end of the key cell, and then serially read the input data input from the parallel-to-serial register.

In the following, the invention is further illustrated by way of example, taking reference to the accompanying drawings. Thereof
Fig.1 is a block diagram of a conventional keyboard,
Fig.2 is a block diagram of a keyboard according to the present invention, and
Fig.3 is a waveform diagram of the transient voltage and the control signal detected by the detect circuit whenever the key cells are pressed or released.

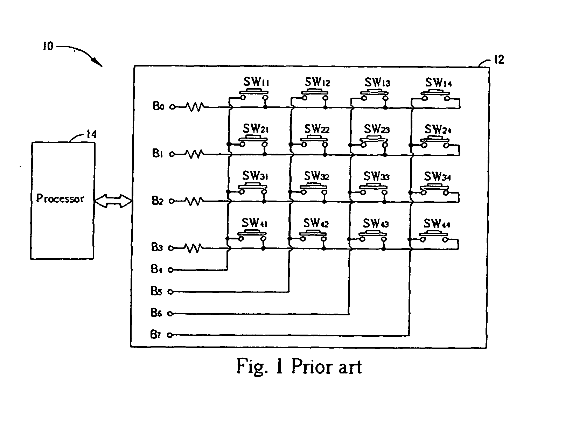

Please refer to Fig.1 showing a block diagram of a conventional keyboard 10. The keyboard 10 includes a matrix key module 12 and a processor 14 electrically connected to the matrix key module 12. The matrix key module 12 includes a plurality of key cells arranged in matrix, and the processor 14 reads input signals on output ends B₀ to B₇ of the key cells within the matrix key module 12 by polling.

It is a disadvantage of the prior art that, whenever any key cell within the matrix key module 12 is pressed, the processor 14 needs to continuously poll the input signals on the output ends B₀ to B₇ of the key cells until every key cell within the matrix key module 12 is released. This continuous polling lowers the efficiency of the processor 14.

The keyboard according to the present invention controls a processor, which inputs signals from the key cells within a key module through a parallel-to-serial register. The processor inputs the key signals according to a control signal generated when a voltage in a capacitor changes, which occurs at the moment a detect circuit detects that a key cell within the key module has been pressed or released.

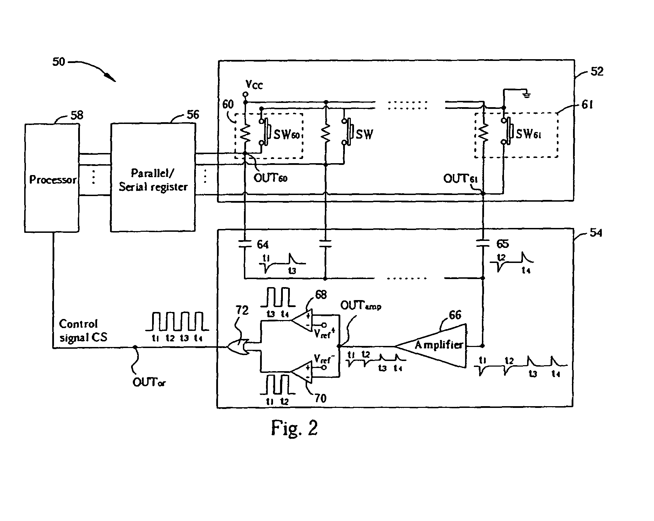

Please refer to Fig.2 showing a block diagram of a keyboard 50 according to the present invention. The keyboard 50 includes a key module 52 which has at least one key cell (for example, key cells 60, 61 in Fig.2), a detect circuit 54 electrically connected to output ends OUT₆₀, OUT₆₁ of the key cells 60, 61 within the key module 52, and a parallel-to-serial register 56 electrically connected to output ends OUT₆₀, OUT₆₁ of the key cells 60, 61. A processor 58 is electrically connected to the parallel-to-serial register 56 and the detect circuit 54 for controlling the parallel-to-serial register 56 to read input data from the output ends OUT₆₀, OUT₆₁ of the key cells 60, 61 according to a control signal CS from the detect circuit 54.

The key cells 60, 61 within the key module 52 include switches SW₆₀, SW₆₁ respectively. The output end OUT₆₀ of the key cell 60 (as well as the output end OUT₆₁ of the key cell 61) is electrically connected to either a first voltage Vcc or a second voltage GND according to the opening and closing of the switch SW₆₀. That is, when the key cell 60 is pressed, the switch SW₆₀ is turned off and the output end OUT₆₀ is electrically connected to the second voltage GND so that a logic low voltage V_{L} is output. On the contrary, when the key cell 60 is released, the switch SW₆₀ is turned on and the output end OUT₆₀ is electrically connected to the first voltage Vcc so that a logic high voltage V_{H} is output. The logic high signal and the logic low signal on the output ends OUT₆₀, OUT₆₁ form the input signals to the parallel-to-serial register 56.

The detect circuit 54 includes one capacitor corresponding to each key cell within the key module 52 (as shown by capacitors 64, 65 corresponding to the key cells 60, 61 respectively within the key module 52 in Fig.2). An amplifier 66 is electrically connected to the capacitors 64, 65 for amplifying the voltage in the capacitors 64, 65. Two comparators 68, 70 are electrically connected to the amplifier 66 for comparing the voltage output by the amplifier 66 and outputting the control signal when the voltage output from the output end OUTₐₘₚ of the amplifier 66 is in a predetermined range. Finally, an OR gate is electrically connected to the comparator 68, 70.

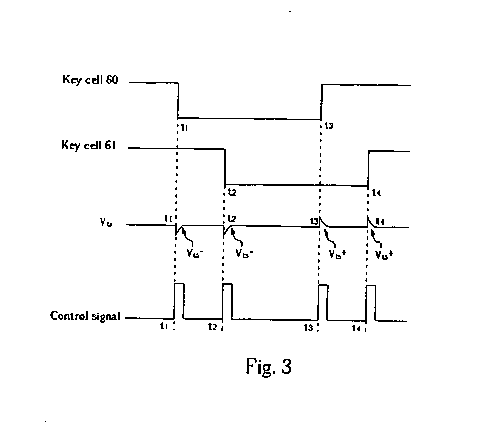

At the moment when the key cell 60 (similar for key cell 61 or any other key cell) within the key module 52 is pressed or released, the switch SW₆₀ of the key cell 60 is accordingly switched off or switched on, and the output end OUT₆₀ is accordingly electrically connected to the second voltage GND or the first voltage Vcc. In this situation, the detect circuit 54 detects a transient voltage Vₜₛ of 100-150mV formed in the capacitor 64 (or the capacitor 65). Please refer to Fig.3 showing a waveform diagram of the transient voltage Vₜₛ and the control signal CS in the capacitors 64, 65 detected by the detect circuit 54 whenever the key cells 60, 61 within the key module 52 of the key board 50 are pressed or released. As shown in Fig.3, at the moment when the key cell 60 (similar for key cell 61) is pressed at time t₁ (or t₂), the switch SW₆₀ of the key cell 60 is switched off, and the output end OUT₆₀ of the key cell 60 is connected to the second voltage GND (i.e. the input signal on the output end OUT₆₀ of the key cell 60 becomes a logic low voltage V_{L}). In this situation, the detect circuit 54 detects a negative transient voltage Vₜₛ₋ in the capacitor 64. On the hand, at the moment when the key cell 60 (similar for key cell 61) is released at time t₃ (or t₄), the switch SW₆₀ of the key cell 60 is switched on, and the output end OUT₆₀ of the key cell 60 is connected to the first voltage Vcc (i.e. the input signal on the output end OUT₆₀ of the key cell 60 becomes a logic high voltage V_{H}). In this situation, the detect circuit 54 detects a positive transient voltage Vₜₛ₊ in the capacitor 64. The amplifier 66 amplifies the positive transient voltage Vₜₛ₊ and the negative transient voltage Vₜₛ₋ and outputs the amplified positive transient voltage Vₜₛ₊₊ and the amplified negative transient voltage Vₜₛ₋₋ into an input end of the comparators 68, 70. In the present invention, the comparators 68, 70 are divided into a positive comparator 68 and a negative comparator 70. The detect circuit 54 outputs the control signal CS from an output end OUTₒᵣ of the OR gate 72 when either the amplified positive transient voltage Vₜₛ₊₊ exceeds a positive reference voltage V_{ref+} on the other input end of the positive comparator 68, or when the amplified negative transient voltage Vₜₛ₋₋ is lower than a negative reference voltage V_{ref-} on the other input end of the negative comparator 70.

After receiving the control signal CS, the processor 58 controls the parallel-to-serial register 56 to first do a parallel input of the output ends of all the key cells within the key module 52, and then gradually inputs the input signals serially. For example, when receiving the control signal CS at time t₁, the processor 58 controls the parallel-to-serial register 56 to first do a parallel input of the input data (01) on the output ends OUT₆₀, OUT₆₁ of all of the key cells 60, 61, and then gradually inputs the input signal (01) serially. As another example, at times t₂, t₃, and t₄, the processor 58 controls the parallel-to-serial register 56 to first do a parallel input of the input data (00), (10), (11), and then gradually reads the input signals (00), (10), (11) serially. The processor 58 can execute specific operations according to these input signals or a variation of the input signals, which is the same as the prior art, so that a further description is hereby omitted.

In contrast to the prior art, the keyboard according to the present invention includes a key module, a detect circuit, a parallel-to-serial register and a processor. The detect circuit detects the variation between current input signals and previous input signals input by the key module, that is, the detect circuit detects whether any of the key cells within the key module is pressed or released. The processor inputs the current input signals only when the input signals change. Therefore, the keyboard according to the present invention solves the problem of the prior art that continuous polling is required whenever any key cell is pressed (e.g. from time t1 to t4 in Fig.3), and thereby improves the efficiency of the processor.

## Claims

1. A keyboard (50) comprising:
a plurality of key cells (60, 61) with an output end (OUT60, OUT61) being selectively connected to a first voltage (Vcc) or a second voltage (GND);
a detect circuit (54) electrically connected to the output end (OUT60, OUT61) of each of the plurality of key cells (60, 61) for generating a control signal (CS); and
a parallel-to-serial register (56) electrically connected to the output end (OUT60, OUT61) of each of the plurality of key cells (60, 61) for reading in parallel signals from the output end (OUT60, OUT61) of each of the plurality of key cells (60, 61) and outputting the read signals in serial form;
**characterized by**:
generating the control signal (CS) whenever the voltage on the output end (OUT60, OUT61) of the plurality of key cells (60, 61) becomes the second voltage (GND) or the first voltage (Vcc); and
a processor (58) electrically connected to the parallel-to-serial register (56) and the detect circuit (54) for receiving the control signal (CS) and for reading the serial signals outputted by the parallel-to-serial register (56) only when the control signal (CS) is generated;
wherein the detect circuit (54) comprises:
a plurality of capacitors (64, 65) each having one end connected to the output end (OUT60, OUT61) of a corresponding one of the plurality of key cells (60, 61);
an amplifying circuit (66) having one input connected to the other end of each capacitor for amplifying the voltages in the capacitors (64, 65); and
a set of comparators (68, 70), each of the set of comparators (68, 70) having an input coupled to an output end (OUTamp) of the amplifying circuit (66) for comparing whether the voltage output from the output end (OUTamp) of the amplifying circuit (66) is in a predetermined range and generating the control signal (CS) accordingly, and having an output end electrically coupled to the processor (58),
wherein the detect circuit (54) further comprises an OR gate (72) having input ends respectively electrically connected to the output ends of the set of comparators (68, 70), and having an output end (OUTor) electrically connected to the processor for outputting the control signal (CS) to the processor (58).

2. The keyboard (50) of claim 1, **characterized in that** the set of comparators (68, 70) comprises a positive comparator (68) for generating the control signal (CS) when the voltage output from the output end (OUTamp) of the amplifying circuit (66) exceeds a positive reference voltage (Vref+), and a negative comparator (70) for generating the control signal (CS) when the voltage output from the output end (OUTamp) of the amplifying circuit (66) is lower than a negative reference voltage (Vref-).

## Patentansprüche

1. Tastatur (50), umfassend:
- eine Mehrzahl von Tastenzellen (60, 61) mit einem Ausgangsende (OUT60, OUT61), das selektiv mit einer ersten Spannung (Vcc) oder einer zweiten Spannung (GND) verbunden ist;
- eine Erfassungsschaltung (54), die elektrisch mit dem Ausgangsende (OUT60, OUT61) von jeder der Mehrzahl der Tastenzellen (60, 61) zum Erzeugen eines Steuersignales (CS) verbunden ist;
- ein parallel-serielles Register (56), das elektrisch mit dem Ausgangsende (OUT60, OUT61) von jeder der Mehrzahl der Tastenzellen (60, 61) zum Lesen paralleler Signale vom Ausgangsende (OUT60, OUT61) von jeder der Mehrzahl der Tastenzellen (60, 61) und zum Ausgeben der gelesenen Signale in serieller Form verbunden ist;
**gekennzeichnet durch**:
- Erzeugen des Steuersignales (CS), so oft die Spannung am Ausgangsende (OUT60, OUT61) der Mehrzahl der Tastenzellen (60, 61) die zweite Spannung (GND) oder erste Spannung (Vcc) wird; und
- einen Prozessor (58), der elektrisch mit dem parallel-seriellen Register (56) und der Erfassungsschaltung (54) zum Empfangen des Steuersignales (CS) und zum Lesen der seriellen Signale verbunden ist, die nur **durch** das parallel-serielle Register (56) ausgegeben werden, wenn das Steuersignal (CS) erzeugt wird;
- wobei die Erfassungsschaltung (54) aufweist:
- eine Mehrzahl von Kondensatoren (64, 65), wobei jeder ein Ende aufweist, das mit dem Ausgangsende (OUT60, OUT61) einer jeweiligen Zelle der Mehrzahl der Tastenzellen (60, 61) verbunden ist;
- eine Verstärkerschaltung (66) mit einem Eingang, der mit dem anderen Ende von jedem Kondensator zum Verstärken der Spannungen in den Kondensatoren (64, 65) verbunden ist; und
- einen Satz von Komparatoren (68, 70), wobei jeder des Satzes von Komparatoren (68, 70) einen Eingang aufweist, der mit einem Ausgangsende (OUTamp) der Verstärkerschaltung (66) zum Vergleich verbunden ist, ob sich die Spannung, die vom Ausgangsende (OUTamp) der Verstärkerschaltung (66) in einem vorbestimmten Bereich befindet und ein entsprechendes Steuersignal (CS) erzeugt, und ein Ausgangsende aufweist, dass elektrisch mit dem Prozessor (58) verbunden ist,
- wobei die Erfassungsschaltung (54) ferner ein OR-Gate (72) mit Eingangsenden aufweist, die jeweils mit dem Ausgangsenden des Satzes von Komparatoren (68, 70) elektrisch verbunden sind, und ein Ausgangsende (OUTor) aufweist, dass elektrisch mit dem Prozessor zum Ausgeben des Steuersignales (CS) an den Prozessor (58) verbunden ist.

2. Tastatur (50) gemäß Anspruch 1, **dadurch gekennzeichnet, dass** der Satz von Komparatoren (68, 70) einen positiven Komparator (68) zum Erzeugen des Steuersignales (CS) aufweist, wenn die Spannung, die vom Ausgangsende (OUTamp) der Verstärkerschaltung (66) ausgegeben wird, eine positive Referenzspannung (Vref+) überschreitet, und einen negativen Komparator (70) zum Erzeugen des Steuersignales (CS) aufweist, wenn die Spannung, die vom Ausgangsende (OUTamp) der Verstärkerschaltung (66) ausgegeben wird, kleiner als eine negative Referenzspannung (Vref-) ist.

## Revendications

1. Clavier (50) comprenant :
une pluralité de cellules de touche (60, 61) avec une extrémité de sortie (OUT60, OUT61) étant sélectivement connectée à une première tension (Vcc) ou une seconde tension (GND) ;
un circuit de détection (54) électriquement connecté à l'extrémité de sortie (OUT60, OUT61) de chacune de la pluralité de cellules de touche (60, 61) pour générer un signal de commande (CS) ; et
un enregistreur parallèle-série (56) connecté électriquement à l'extrémité de sortie (OUT60, OUT61) de chacune de la pluralité de cellules de touche (60, 61) pour lire en parallèle des signaux en provenance de l'extrémité de sortie (OUT60, OUT61) de chacune de la pluralité de cellules de touche (60, 61) et produire en sortie les signaux de lecture sous forme sérielle;
**caractérisé par** :
la génération du signal de commande (CS) à chaque fois que la tension sur l'extrémité de sortie (OUT60, OUT61) de la pluralité de cellules de touche (60, 61) devient la seconde tension (GND) ou la première tension (Vcc) ; et
un processeur (58) connecté électriquement à l'enregistreur parallèle-série (56) et au circuit de détection (54) pour recevoir le signal de commande (CS) et pour lire les signaux sériels produits en sortie par l'enregistreur parallèle-série (56) uniquement lorsque le signal de commande (CS) est généré ;
dans lequel le circuit de détection (54) comprend :
une pluralité de condensateurs (64, 65) ayant chacun une extrémité connectée à l'extrémité de sortie (OUT60, OUT61) de l'une correspondante de la pluralité de touches de cellules (60, 61) ;
un circuit amplificateur (66) ayant une entrée connectée à l'autre extrémité de chaque condensateur pour amplifier les tensions dans les condensateurs (64, 65) ; et
un ensemble de comparateurs (68, 70), chacun de l'ensemble de comparateurs (68, 70) ayant une entrée couplée à une extrémité de sortie (OUTamp) du circuit amplificateur (66) pour comparer si la tension de sortie en provenance de l'extrémité de sortie (OUTamp) du circuit amplificateur (66) est dans une plage prédéterminée et générer le signal de commande (CS) en conséquence, et ayant une extrémité de sortie couplée électriquement au processeur (58),
dans lequel le circuit de détection (54) comprend en outre une porte OU (72) ayant des extrémités d'entrée connectées électriquement respectivement aux extrémités de sortie de l'ensemble de comparateurs (68, 70), et ayant une extrémité de sortie (OUTor) connectée électriquement au processeur pour produire en sortie le signal de commande (CS) au processeur (58).

2. Clavier (50) selon la revendication 1, **caractérisé en ce que** l'ensemble de comparateurs (68, 70) comprend un comparateur positif (68) pour générer le signal de commande (CS) lorsque la tension de sortie de l'extrémité de sortie (OUTamp) du circuit amplificateur (66) dépasse une tension de référence positive (Vref+), et un comparateur négatif (70) pour générer le signal de commande (CS) lorsque la tension de sortie en provenance de l'extrémité de sortie (OUTamp) du circuit amplificateur (66) est inférieure à une tension de référence négative (Vref-).
